(19) Europäisches Patentamt
European Patent Office
Office européen des brevets

(11) **EP 3 337 026 B1**

(12) **EUROPEAN PATENT SPECIFICATION**

(45) Date of publication and mention
of the grant of the patent:
**09.09.2020 Bulletin 2020/37**

(51) Int Cl.:
*H02M 7/00* *(2006.01)*      *H01J 17/00* *(2006.01)*
*H02J 1/00* *(2006.01)*

(21) Application number: **16204368.1**

(22) Date of filing: **15.12.2016**

(54) **MONITORING ASSEMBLY**

ÜBERWACHUNGSANORDNUNG

ENSEMBLE DE SURVEILLANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.06.2018 Bulletin 2018/25**

(73) Proprietor: **General Electric Technology GmbH
5400 Baden (CH)**

(72) Inventor: **DAVIDSON, Colin Charnock
Stafford, Staffordshire ST17 4PS (GB)**

(74) Representative: **Freigutpartners IP Law Firm
Hahnrainweg 4
5400 Baden (CH)**

(56) References cited:
**US-A- 2 575 232      US-A- 2 928 026
US-A- 3 119 968      US-A- 4 156 264**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This invention relates to a monitoring assembly for a gas tube switching device which is operable in a plurality of different conducting modes, and also to such a gas tube switching device, preferably for use in high voltage direct current (HVDC) power transmission, having the aforementioned monitoring assembly operatively associated therewith. For example, US2575232A discloses electron tube protective systems, and particularly systems for protecting electron tubes from abnormal localized currents. Moreover, US4156264A discloses apparatus for the protection of devices powered by high voltage, high current energy sources.

The latest gas tube switching devices, for use in HVDC power transmission, have different conducting modes, in which they are able to operate when turned on and conducting current therethrough. The various conducting modes have different operating characteristics, some of which are more desirable than others.

According to a first aspect of the invention there is provided a monitoring assembly, for a gas tube switching device operable in a plurality of different conducting modes, the monitoring assembly including the features of claim 1.

The inclusion of a monitoring module which is able to distinguish in real time at least one conducting mode from the or each other conducting mode advantageously permits, for example, the identification of when the switching device is operating in a given conducting mode with desirable characteristics, and thereby can help to ensure that the switching device is operating in an optimum conducting mode.

The monitoring module in use distinguishes the at least one conducting mode by considering, while the switching device is conducting, one or more of:

- an electromagnetic emission from the switching device; and
- an operating temperature of the switching device.

Optionally, the monitoring module in use distinguishes the at least one conducting mode by further considering, while the switching device is conducting, an on-state voltage across the switching device.

Each of the foregoing characteristics of the switching device while it is conducting varies according to the conducting mode of the switching device and so provides a useable way of discriminating between different conducting modes.

In a preferred embodiment of the invention the monitoring module considers an on-state voltage across the switching device and includes a voltage monitoring circuit configured to in use provide a monitoring output proportional to the voltage arising across the switching device, the voltage monitoring circuit operating in a first mode while the switching device is conducting in which it communicates the whole voltage magnitude arising across the switching device, and the voltage monitoring circuit operating in a second mode while the switching device is not conducting in which it truncates at least a portion of the whole voltage magnitude arising across the switching device.

Having a voltage monitoring circuit which operates in first and second modes that communicate different amounts of the whole voltage magnitude arising across the switching device depending on whether the switching device is conducting or not, allows the voltage monitoring circuit to accurately reflect the actual amount of a relatively small voltage magnitude, e.g. several hundred volts, arising across the switching device while it is conducting, i.e. while the switching device is turned on, and to ignore at least some of a much higher voltage magnitude, e.g. several hundred kilovolts, arising across the switching device while it is not conducting, i.e. while the switching device is turned off. Meanwhile ignoring a least some of a much higher voltage magnitude arising while the switching device is turned off can, in turn, help to protect downstream analysis equipment calibrated to handle only a relatively low monitoring output. The voltage monitoring circuit may include a voltage divider stage having a monitoring output configured to provide a monitoring output voltage proportional to the voltage arising across the switching device.

Such an arrangement usefully provides a monitoring output in the form of a proportional voltage which can be readily and reliably used by downstream analysis equipment to establish one or more given conducting modes of the switching device.

In another preferred embodiment of the invention the voltage divider stage includes a limiter to truncate at least a portion of the whole voltage magnitude arising across the switching device while the switching device is not conducting.

The inclusion of a limiter provides a practical way of protecting, e.g. downstream analysis equipment, from a relatively high monitoring output voltage that might otherwise be provided as a result of a high voltage magnitude arising across the switching device while it is not conducting.

Optionally the limiter is or includes a non-linear resistor electrically connected across the monitoring output of the voltage divider stage.

Preferably the limiter retains only a lowermost portion of the whole voltage magnitude arising across the switching device while the switching device is not conducting.

Such features desirably clip the magnitude of the monitoring output voltage, while the switching device is not conducting, at a level suitable to prevent damage occurring to, e.g. downstream analysis equipment.

The limiter may be or include a switching element configured to electrically isolate the monitoring output from the voltage divider stage while the switching device is not conducting.

Preferably during normal use the switching element removes the whole of the voltage magnitude arising across the switching device while the switching device is not conducting.

The foregoing features isolate completely, e.g. any downstream analysis equipment, from the relatively high voltage magnitude arising across the switching device when not conducting, and thereby help to prevent such equipment being damaged, e.g. by an overvoltage.

Optionally the voltage monitoring circuit includes a further voltage divider stage having a control output configured to provide a control output voltage proportional to the voltage arising across the switching device.

The additional inclusion of a further voltage divider stage which provides a control output voltage proportional to the voltage arising across the switching device advantageously permits the measurement of very high voltages, e.g. several hundred kilovolts, across the switching device, which can be used to help control switching on and off of the device, e.g. when included within a HVDC power converter.

In a further preferred embodiment of the invention the divider ratio of the further voltage divider stage having a control output is greater than the divider ratio of the voltage divider stage having a monitoring output.

In a still further preferred embodiment of the invention the divider ratio of the further voltage divider stage is multiple orders of magnitude greater than that of the other voltage divider.

Such features permit the further voltage divider stage to handle, and thereby measure, relatively high voltage magnitudes, e.g. of several hundred kilovolts, arising across the switching device while it is not conducting, whereas the other voltage divider has a greater sensitivity whereby it is able accurately to reflect the actual amount of a relatively small voltage magnitude, e.g. several hundred volts, arising across the switching device while it is conducting.

Preferably the monitoring module considers an electromagnetic emission spectrum of the switching device and includes an electromagnetic detector arranged in electromagnetic communication with the switching device.

Such an arrangement permits, for example, the detection of a characteristic wavelength of electromagnetic radiation which signifies operation of the switching device in corresponding conducting mode.

According to a second aspect of the invention there is provided a system comprising a gas tube switching device, for use in HVDC power transmission, operable in a plurality of different conducting modes and having a monitoring assembly as described hereinabove connected therewith.

The system shares the benefits associated with the corresponding features of the monitoring assembly.

There now follows a brief description of preferred embodiments of the invention, by way of non-limiting example, with reference being made to the following figures in which:

Figure 1 shows a schematic view of a monitoring assembly according to a first embodiment of the invention;
Figure 2 shows a schematic view of a monitoring assembly according to a second embodiment of the invention;
Figure 3 shows a schematic view of a monitoring assembly according to a third embodiment of the invention;
Figure 4 shows a schematic view of a monitoring assembly according to a fourth embodiment of the invention; and
Figure 5 shows a schematic view of a monitoring assembly according to a fifth embodiment of the invention.

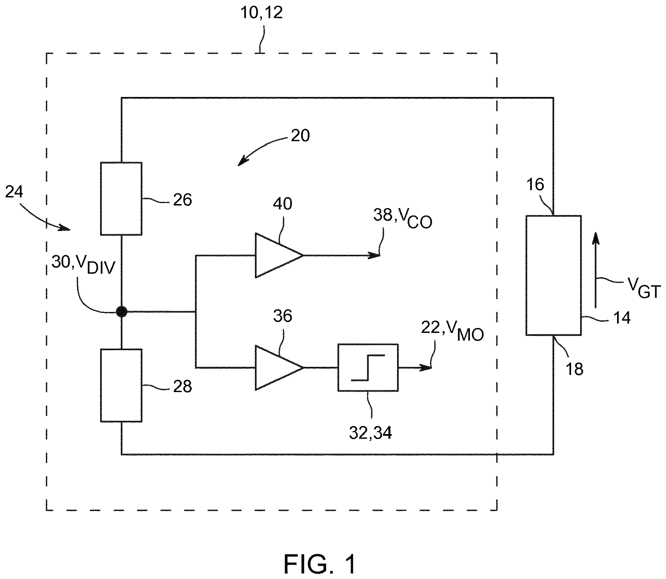

A monitoring assembly according to a first embodiment of the invention is designated generally by reference numeral 10, as shown schematically in Figure 1.

The first monitoring assembly 10 includes a monitoring module 12 to distinguish, in real time, at least one conducting mode from a plurality of conducting modes of a gas tube switching device 14 the monitoring module 12 is connected across.

More particularly, the monitoring module 12 is connected in parallel with respective anode and cathode connection terminals 16, 18 of the gas tube switching device 14, and by way of example the switching device 14 is operable, i.e. when turned on, in four different conducting modes which can be characterised as follows:

(i) a magnetron mode with an on-state voltage across the anode and cathode connection terminals 16, 18 thereof of approximately 200V to 300V;
(ii) a low voltage mode with an on-state voltage across the anode and cathode connection terminals 16, 18 thereof of approximately 70V to 120V
(iii) a very low voltage mode with an on-state voltage across the anode and cathode connection terminals 16, 18 thereof of approximately 40V to 60V; and
(iv) a metal mode with an on-state voltage across the anode and cathode connection terminals 16, 18 thereof of approximately 6V to 30V.

When operating in the metal mode the loss of cathode material by the switching device 14 is very high, and similarly when operating in the magnetron mode the loss of cathode material by the switching device 14 is high. In contrast the loss of cathode material when the switching device 14 is operating in the very low voltage mode is only low, while it is negligible when the switching device 14 is operating in the low voltage mode.

As a consequence it is desirable to help to ensure that the switching device 14 operates in the low voltage conducting mode when it is conducting, i.e. when it is turned on.

Meanwhile when not conducting, i.e. when turned off, a voltage $V_{GT}$ typically of approximately 100kV to 200kV, but possibly as high as 500kV, arises across the anode and cathode connection terminals 16, 18 of the switching device 14.

In other examples, the monitoring module may be connected in parallel with a gas tube switching device that is operable in more than or less than four different conducting modes, and those other conducting modes may have characteristics that differ to those of the conducting modes set out above, such that it may be desirable to operate in a different one or more of the other conducting modes. In any case, the invention is defined by the features of claim

In still further embodiments of the invention the monitoring module may consider an on-state voltage of a gas tube switching device with which it is, in use, connected in parallel in the form of a grid-cathode voltage, i.e. a voltage between the cathode of the gas tube switching device and the gate control grid of the said switching device via which the device can be turned on and off.

The monitoring module 12 shown in Figure 1 distinguishes each different conducting mode by considering, while the switching device 14 is conducting, the on-state voltage across the switching device 14.

More particularly, the monitoring module 12 includes a voltage monitoring circuit 20 that is configured in use to provide a monitoring output 22 which is proportional to the voltage $V_{GT}$ arising across the switching device 14.

The voltage monitoring circuit 20 operates in a first mode while the switching device 14 is conducting in which it communicates the whole voltage magnitude $V_{GT}$ arising across the switching device 14, and it operates in a second mode while the switching device 14 is not conducting in which it truncates at least a portion of the whole voltage magnitude $V_{GT}$ arising across the switching device 14.

More particularly still, the voltage monitoring circuit 20 includes a voltage divider stage 24 which has a monitoring output 22 that is configured to provide a monitoring output voltage $V_{MO}$ proportional to the voltage $V_{GT}$ arising across the switching device 14.

In the embodiment shown the voltage divider stage 24 includes first and second resistors 26, 28 which provide the voltage divider stage 24 with a divider ratio of approximately 50,000:1. In other words, the relative magnitudes of the first and second resistors 26, 28 are chosen such that a divider voltage $V_{DIV}$ arising at a divider terminal 30 between the first and second resistors 26, 28, i.e. as given by

$$V_{DIV} = \frac{R_{28}}{R_{28}+R_{26}} \times V_{GT} \ ,$$

is approximately 1/50,000th of the voltage $V_{GT}$ arising across the switching device 14.

Each of the first and second resistors 26, 28 optionally includes a grading capacitor (not shown) connected in parallel therewith to increase the bandwidth of the voltage divider stage 24.

The voltage divider stage 24 meanwhile also includes a limiter 32 to truncate a portion of the whole voltage magnitude $V_{GT}$ arising across the switching device 14. In the embodiment shown the limiter 32 takes the form of a non-linear element 34 which limits the level of voltage that is able to pass therethrough to approximately 10mV. In this way the limiter 32 retains only a lowermost portion, e.g. around only up to 500V, of the whole 500kV voltage $V_{GT}$ arising across the switching device 14 while it is not conducting.

A first buffer 36 is shown connected in series between the divider terminal 30 and the limiter 32 to prevent any signals, e.g. from downstream measurement or control equipment, from passing onto the input side of the first buffer 36 and potentially causing interference elsewhere in the monitoring module 12.

In addition to the foregoing, the voltage monitoring circuit 20 also includes a control output 38 that is configured to provide a control output voltage Vco proportional to the voltage $V_{GT}$ arising across the switching device 14. The control output 38 is connected in series with the divider terminal 30 via a second buffer 40 which similarly again prevents any signals, e.g. from downstream measurement or control equipment, from passing onto the input side of the second buffer 40 and potentially causing interference elsewhere in the monitoring module 12.

In the foregoing manner the first buffer 36 prevents signals from measurement or control equipment downstream thereof from interfering with the control output voltage Vco at the control output 38, while the second buffer 40 prevents signals from measurement or control equipment downstream thereof from interfering with the monitoring output voltage $V_{MO}$ at monitoring output 22.

In use, while the switching device 14 is not conducting, i.e. while the switching device 14 is turned off, the voltage $V_{GT}$ arising across the switching device 14 is approximately 500kV, and the resulting divider voltage $V_{DIV}$ appearing at the divider terminal 30 is approximately 10V, i.e. 1/50,000th of 500kV.

This divider voltage $V_{DIV}$ is then output, via the second buffer 40, at the control output 38 in the form of a 10V control output voltage Vco which can be used to help control operation of the switching device 14, i.e. control switching on and off of the device 14, e.g. when included within a HVDC power converter.

At the same time, the limiter 32 limits the level of voltage that is able to pass through to the monitoring output 22 to approximately 10mV, such that the monitoring output voltage $V_{MO}$ does not exceed 10mV. In other words, while the switching device 14 is not conducting, the voltage monitoring circuit 20 operates in a second mode whereby the limiter 32 therein truncates a portion of the whole voltage $V_{GT}$ arising across the switching device 14 and retains only a lowermost portion, e.g. around only up to 500V, of the whole 500kV voltage $V_{GT}$ arising across the switching device 14.

Meanwhile, during periods when the switching device 14 is conducting, i.e. while the switching device 14 is turned on, the voltage $V_{GT}$ arising across the switching device 14 is determined by the nature of the conducting mode in which the switching device 14 is operating.

For example, if the switching device 14 is operating in the desired low voltage mode, the voltage $V_{GT}$ arising across the switching device 14 will be around 70V to 120V, which will lead to a divider voltage $V_{DIV}$ at the divider terminal 30 of approximately 1.4mV to 2.4mV, i.e. 1/50,000th of 70V to 120V. Such a relatively low voltage is not impacted by the limiter 32 and so passes through in its entirety to be output at the monitoring output 22 as a 1.4mV to 2.4mV monitoring output voltage $V_{MO}$. In other words, while the switching device 14 is conducting, the voltage monitoring circuit 20 operates in a first mode whereby the whole voltage $V_{GT}$ arising across the switching device 14 is communicated to the monitoring output 22.

In contrast, if the switching device 14 is operating in the undesirable metal mode, the voltage $V_{GT}$ arising across the switching device 14 will be around 6V to 30V, which will lead to a divider voltage $V_{DIV}$ at the divider terminal 30 of approximately 120$\mu$V to 600$\mu$V. This voltage is similarly not affected by the limiter 32 and so passes through in its entirety to be output at the monitoring output 22 as a 120$\mu$V to 600$\mu$V monitoring output voltage $V_{MO}$.

Accordingly the monitoring module 12 is able to distinguish, in real time, between the low voltage conducting mode and the metal mode (as well as each of the other two conducting modes which will similarly give rise to monitoring output voltages $V_{MO}$ that differ from that arising as a result of operating in the low voltage conducting mode).

In further embodiments of the invention (not shown) the monitoring output voltage $V_{MO}$ at the monitoring output 22 may pass to an amplifier to boost it to a useful level of a few volts.

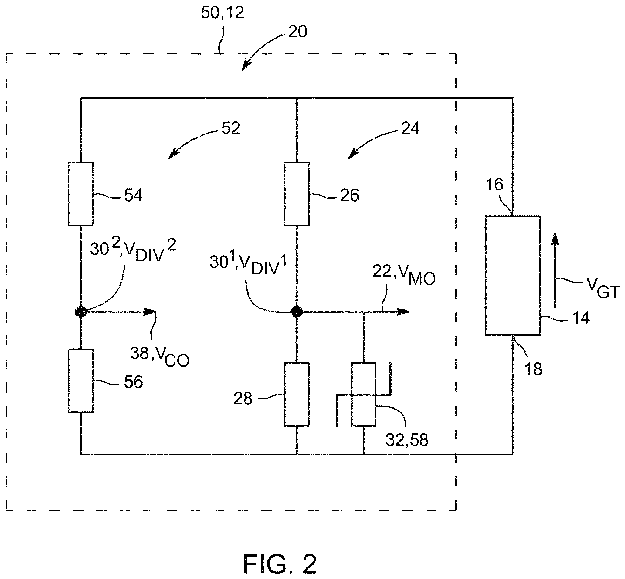

A monitoring assembly according to a second embodiment of the invention is designated generally by reference numeral 50, as shown schematically in Figure 2.

The second monitoring assembly 50 is similar to the first monitoring assembly 10 and like features share the same reference numerals.

The second monitoring assembly 50 differs, however, in that as well as a first voltage divider stage 24 formed of first and second resistors 26, 28 it also includes a further, second voltage divider stage 52 formed by third and fourth resistors 54, 56.

The first voltage divider stage 24 again has a monitoring output 22 that is configured to provide a monitoring output voltage $V_{MO}$ proportional to the voltage $V_{GT}$ arising across the switching device 14, but the relative magnitudes of the first and second resistors 26, 28 are chosen such that a first divider voltage $V_{DIV}^1$ arising at a first divider terminal $30^1$ between the first and second resistors 26, 28 is instead approximately 1/50th of the voltage $V_{GT}$ arising across the switching device 14, i.e. the first voltage divider stage 24 is provided with a divider ratio of approximately 50:1.

In addition, the first divider stage 24 includes a limiter 32 which is instead in the form of a non-linear resistor 58 that is electrically connected across the monitoring output 22 of the first voltage divider stage 24. The non-linear resistor 58 is so connected and sized to limit the level of voltage appearing at the monitoring output 22 to not more than approximately 10V.

In the meantime the second voltage divider stage 52 has a control output 38 which is configured to provide a control output voltage Vco proportional to the voltage $V_{GT}$ arising across the switching device 14. In this regard the relative magnitudes of the third and fourth resistors 54, 56 are chosen such that a second divider voltage $V_{DIV}^2$ arising at a second divider terminal $30^2$ between the third and fourth resistors 54, 56 is approximately 1/50,000th of the voltage $V_{GT}$ arising across the switching device 14, i.e. the second voltage divider stage 52 is provided with a divider ratio of approximately 50,000:1.

It follows that the divider ratio of the further, second voltage divider stage 52, at 50,000:1, is greater than the divider ratio of the first voltage divider stage 24, at just 50:1, and indeed is three orders of magnitude, i.e. 1,000 times, greater than the divider ratio of the first voltage divider stage 24.

Each of the first, second, third and fourth resistors 26, 28, 54, 56 may again optionally include a grading capacitor (not shown) connected in parallel therewith.

In use of the second switching assembly 50, while the switching device 14 is not conducting, i.e. while the switching device 14 is turned off, the voltage $V_{GT}$ arising across the switching device 14 is approximately 500kV.

The resulting second divider voltage $V_{DIV}^2$ appearing at the second divider terminal $30^2$ is approximately 10V, i.e. 1/50,000th of 500kV. This second divider voltage $V_{DIV}^2$ is then output, directly, at the control output 38 in the form of a 10V control output voltage Vco which can again be used to help control operation of the switching device 14.

At the same time, i.e. while the switching device 14 is not conducting, a first divider voltage $V_{DIV}^1$ appears at the first divider terminal $30^1$ which is approximately 10kV, i.e. 1/50th of 500kV. This second divider voltage $V_{DIV}^2$ is truncated by the non-linear resistor 58 such that a monitoring output voltage $V_{MO}$ of not more than 10V appears at the monitoring output 22.

Meanwhile, during periods when the switching device 14 is conducting, i.e. while the switching device 14 is turned on, the voltage $V_{GT}$ arising across the switching device 14 is again determined by nature of the conducting mode in which the switching device 14 is operating.

For example, if the switching device 14 is operating in the desired low voltage mode, the voltage $V_{GT}$ arising across the switching device 14 will be around 70V to 120V, which will lead to a first divider voltage $V_{DIV}1$ at the first divider terminal $30^1$ of approximately 1.4V to 2.4V, i.e. 1/50th of 70V to 120V. Such voltages are not impacted by the non-linear resistor 58 and so pass through in their entirety to be output at the monitoring output 22 as a 1.4V to 2.4V monitoring output voltage $V_{MO}$.

Accordingly the monitoring output voltage $V_{MO}$, which differs according to the conducting mode of the switching device 14 while it is conducting, is again indicative of the conducting mode in which the switching device 14 is operating. Moreover, the increased magnitude of the monitoring output voltage $V_{MO}$ output by the voltage monitoring circuit 20 in the second monitoring assembly 50 reduces the susceptibility of such an output to, e.g. distortion and contamination by noise.

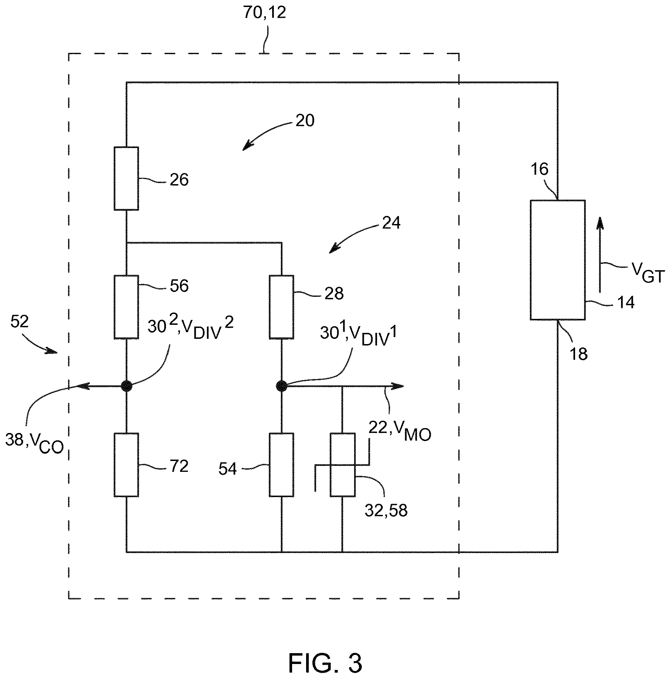

A monitoring assembly according to a third embodiment of the invention is designated generally by reference numeral 70, as shown schematically in Figure 3.

The third monitoring assembly 70 is similar to the second monitoring assembly 50 and like features share the same reference numerals.

Accordingly the third monitoring assembly 70 includes a first voltage divider stage 24 defined by first and second series-connected resistors 26, 28 and third resistor 54, and also a further, second voltage divider stage 52 defined by the first resistor 26 connected in series with a fourth resistor 56 and a fifth resistor 72. The first, second, third, fourth and fifth resistors 26, 28, 54, 56, 72 have the following relative magnitudes: 50,000, 1,000, 100, 1,000 and 1, respectively.

The first voltage divider stage 24 again has a monitoring output 22 that is configured to provide a monitoring output voltage $V_{MO}$ proportional to the voltage $V_{GT}$ arising across the switching device 14, and the first, second and third resistors 26, 28, 54 have relative magnitudes such that a first divider voltage $V_{DIV}1$ arising at a first divider terminal $30^1$ between the second and third resistors 28, 54 is approximately 1/500th (i.e. (100/(50,000 + 1,000) of the voltage $V_{GT}$ arising across the switching device 14, i.e. the first voltage divider stage 24 is provided with a divider ratio of approximately 500:1.

The first divider stage 24 again includes a limiter 32 in the form of a non-linear resistor 58 which is electrically connected across the monitoring output 22 of the first voltage divider stage 24. The non-linear resistor 58 is so connected and sized to limit the level of voltage appearing at the monitoring output 22 to not more than approximately 1V, which desirably protects, e.g. any downstream analysis equipment.

In the meantime the second voltage divider stage 52 again has a control output 38 which is configured to provide a control output voltage Vco proportional to the voltage $V_{GT}$ arising across the switching device 14, with the relative magnitudes of the first, fourth and fifth resistors 26, 56, 82 being set out as above, such that a second divider voltage $V_{DIV}2$ arising at a second divider terminal $30^2$ between the fourth and fifth resistors 56, 82 is approximately 1/50,000th (i.e. 1/(1,000 + 50,000) of the voltage $V_{GT}$ arising across the switching device 14, i.e. the second voltage divider stage 52 is provided with a divider ratio of approximately 50,000:1.

The divider ratio of the further, second voltage divider stage 52, at 50,000:1, is therefore again greater than the divider ratio of the first voltage divider stage 24, at just 500:1, and indeed is two orders of magnitude, i.e. 100 times, greater than the divider ratio of the first voltage divider stage 24.

Each of the first, second, third, fourth and fifth resistors 26, 28, 54, 56, 82 may again optionally include a grading capacitor (not shown) connected in parallel therewith.

In use of the third monitoring assembly 70, while the switching device 14 is not conducting, i.e. while the switching device 14 is turned off, the voltage $V_{GT}$ arising across the switching device 14 is again approximately 500kV.

The resulting second divider voltage $V_{DIV}2$ appearing at the second divider terminal $30^2$ is approximately 10V, i.e. 1/50,000th of 500kV. This second divider voltage $V_{DIV}2$ is then output, directly, at the control output 38 in the form of a 10V control output voltage Vco which can again be used to help control operation of the switching device 14.

At the same time, i.e. while the switching device 14 is not conducting, a first divider voltage $V_{DIV}1$ appears at the first divider terminal $30^1$ which would ordinarily be approximately 1,000V, i.e. 1/500th of 500kV but the first divider voltage $V_{DIV}1$ is truncated by the non-linear resistor 58 such that a monitoring output voltage $V_{MO}$ of not more than 1V appears at the monitoring output 22.

Meanwhile, during periods when the switching device 14 is conducting, e.g. while the switching device 14 is operating in the desired low voltage mode, the voltage $V_{GT}$ arising across the switching device 14 will be around 70V to 120V, which will lead to a first divider voltage $V_{DIV}1$ at the first divider terminal $30^1$ of approximately 0.14V to 0.24V, i.e. 1/500th of 70V to 120V. Such voltages are not impacted by the non-linear resistor 58 and so pass through in their entirety to be output at the monitoring output 22 as a 0.14V to 0.24V monitoring output voltage $V_{MO}$.

Accordingly the monitoring output voltage $V_{MO}$, which differs according to the conducting mode of the switching device 14 while it is conducting, is again indicative of the conducting mode in which the switching device 14 is operating.

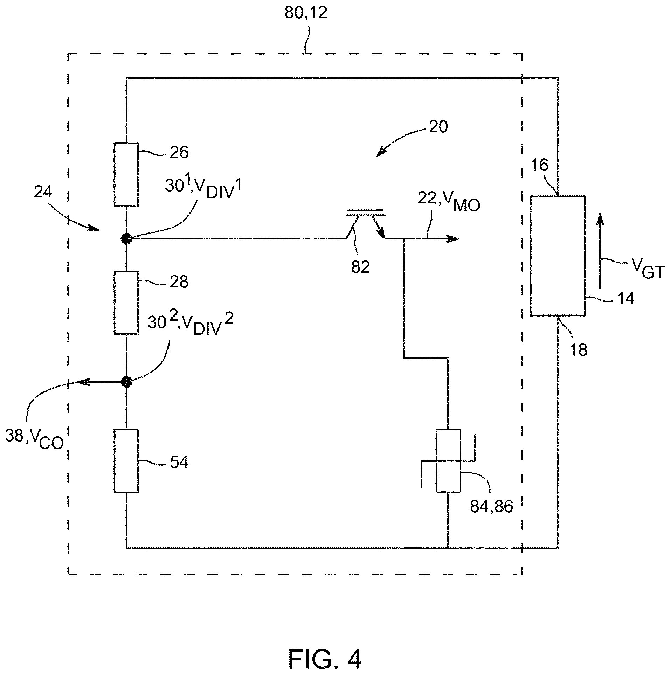

A monitoring assembly according to a fourth embodiment of the invention is designated generally by reference numeral 80, as shown schematically in Figure 4.

The fourth monitoring assembly 80 is similar to each of the second and third monitoring assemblies 50; 70and like features share the same reference numerals.

Accordingly the fourth monitoring assembly 80 includes a first voltage divider stage 24 defined by a first resistor 26 and series-connected, second and third resistors 28, 54, and also a further, second voltage divider stage 52 defined by the first and second resistors 26, 28 connected in series and a third resistor 56. The first, second and third resistors 26, 28, 54 have the following relative magnitudes: 50,000, 1,000, and 1, respectively.

The first voltage divider stage 24 again has a monitoring output 22 that is configured to provide a monitoring output voltage $V_{MO}$ proportional to the voltage $V_{GT}$ arising across the switching device 14, and the first, second and third resistors 26, 28, 54 have relative magnitudes such that a first divider voltage $V_{DIV}1$ arising at a first divider terminal $30^1$ between the first and second resistors 26, 28 is approximately $1/50^{th}$ (i.e. ((1000 + 1)/(50,000) of the voltage $V_{GT}$ arising across the switching device 14, i.e. the first voltage divider stage 24 is provided with a divider ratio of approximately 50:1.

In contrast, however, to each of the aforementioned second and third monitoring assemblies 50; 70, the first divider stage 24 includes a limiter 32 in the form of a switching element 82, such as a semiconductor switch, which is configured to electrically isolate the monitoring output 22 of the voltage monitoring circuit 20 from the first voltage divider stage 24 while the switching device 14 is not conducting. Moreover, during normal use of the switching element 14, the switching element 82 removes the whole of the voltage magnitude arise across the switching device 14 while the switching device is not conducting, as described in more detail hereinbelow.

Optionally the first voltage divider stage 24 additionally includes a further limiter 84 in the form again of a non-linear resistor 86. The further limiter 84 is calibrated so as to limit the voltage appearing at the monitoring output 22 to, e.g. a desired upper threshold, in order to provide backup protection for, e.g. any downstream analysis equipment, in the event of the switching element failing to short-circuit.

In the meantime the second voltage divider stage 52 again has a control output 38 which is configured to provide a control output voltage Vco proportional to the voltage $V_{GT}$ arising across the switching device 14, with the relative magnitudes of the first, second and third resistors 26, 28, 54 being set out as above, such that a second divider voltage $V_{DIV}2$ arising at a second divider terminal $30^2$ between the second and third resistors 28, 54 is approximately $1/50,000^{th}$ (i.e. 1/(1,000 + 50,000) of the voltage $V_{GT}$ arising across the switching device 14, i.e. the second voltage divider stage 52 is provided with a divider ratio of approximately 50,000:1.

The divider ratio of the further, second voltage divider stage 52, at 50,000:1, is therefore again greater than the divider ratio of the first voltage divider stage 24, at just 50:1, and indeed is three orders of magnitude, i.e.

1000 times, greater than the divider ratio of the first voltage divider stage 24.

Each of the first, second and third resistors 26, 28, 54 may again optionally include a grading capacitor (not shown) connected in parallel therewith.

In use of the fourth monitoring assembly 80, while the switching device 14 is not conducting, i.e. while the switching device 14 is turned off, the voltage $V_{GT}$ arising across the switching device 14 is again approximately 500kV.

The resulting second divider voltage $V_{DIV}2$ appearing at the second divider terminal $30^2$ is approximately 10V, i.e. $1/50,000^{th}$ of 500kV. This second divider voltage $V_{DIV}2$ is then output, directly, at the control output 38 in the form of a 10V control output voltage Vco which can again be used to help control operation of the switching device 14.

At the same time, i.e. while the switching device 14 is not conducting, a first divider voltage $V_{DIV}1$ appears at the first divider terminal $30^1$ which is approximately 10kV, i.e. $1/50^{th}$ of 500kV. This second divider voltage $V_{DIV}2$ is completely isolated from the monitoring output 22 by selectively opening the switching element 82 to temporarily disconnect the monitoring output 22 from the first divider terminal $30^1$. As a consequence the monitoring output voltage $V_{MO}$ appearing at the monitoring output is zero, i.e. the whole of the voltage magnitude $V_{GT}$ arising across the switching device 14 has been removed by the switching element 82.

Meanwhile, during periods when the switching device 14 is conducting, e.g. while the switching device 14 is operating in the desired low voltage mode, the voltage $V_{GT}$ arising across the switching device 14 will be around 70V to 120V, which will lead to a first divider voltage $V_{DIV}1$ at the first divider terminal $30^1$ of approximately 1.4V to 2.4V, i.e. $1/50^{th}$ of 70V to 120V. The switching element 82 is closed and so such voltages pass directly from the first divider terminal $30^1$ in their entirety to be output at the monitoring output 22 as a 1.4V to 2.4V monitoring output voltage $V_{MO}$.

Accordingly the monitoring output voltage $V_{MO}$, which differs according to the conducting mode of the switching device 14 while it is conducting, is again indicative of the conducting mode in which the switching device 14 is operating.

In other embodiments of the invention (not shown) the monitoring module may instead consider an electromagnetic emission from the switching device and include an electromagnetic detector arranged in electromagnetic communication with the gas tube switching device being monitored.

One way in which the electromagnetic detector may be arranged in electromagnetic communication with the switching device is via an electromagnetic radiation conduit, such as an optical fibre, which may have one end arranged to receive electromagnetic radiation emitted from a region between the anode and cathode connection terminals of a switching device and another, opposite end arranged to pass the received electromagnetic radiation to the electromagnetic detector. In such circumstances the electromagnetic detector, which could be arranged at ground voltage potential, could take the form of a spectroscope.

Alternatively, the electromagnetic detector could be arranged to receive directly the electromagnetic radiation emitted from the region between the anode and cathode connection terminals of a switching device. A radiation-sensitive integrated circuit, such as a charge-coupled device could be used as an electromagnetic detector in these circumstances since it would permit the detection and storage of electromagnetic emission data at the voltage potential of the switching device.

Optionally either of the aforementioned electromagnetic detectors could be tuned to detect characteristic wavelengths of emitted electromagnetic radiation corresponding to the different conducting modes of the switching device being monitored.

In still further embodiments of the invention (also not shown), the monitoring module may instead consider an operating temperature of the switching device. For example, the cathode connection terminal of a gas tube switching device increases in temperature following prolonged operation in the magnetron conducting mode, and such an increase could be measured and thereby detected by, e.g. a temperature sensor coupled with the cathode connection terminal.

## Claims

1. A monitoring assembly (10; 50; 70; 80; 90), for a gas tube switching device (14) operable in a plurality of different conducting modes, the monitoring assembly (10; 50; 70; 80; 90) **characterized by** including a monitoring module (12) connectable in parallel with respective anode and cathode connection terminals (16, 18) of the gas tube switching device (14) to distinguish in real time at least one conducting mode from four different conducting modes which may be characterised as follows:

   (i) a magnetron mode with an on-state voltage across the anode and cathode connection terminals (16, 18) thereof of approximately 200V to 300V;
   (ii) a low voltage mode with an on-state voltage across the anode and cathode connection terminals (16, 18) thereof of approximately 70V to 120V
   (iii) a very low voltage mode with an on-state voltage across the anode and cathode connection terminals (16, 18) thereof of approximately 40V to 60V; and
   (iv) a metal mode with an on-state voltage across the anode and cathode connection terminals (16, 18) thereof of approximately 6V to 30V; wherein the monitoring module (12) in use distinguishes the at least one conducting mode by considering, while the switching device is conducting, one or more of:

   - an electromagnetic emission from the switching device (14); and
   - an operating temperature of the switching device (14).

2. A monitoring assembly (10; 50; 70; 80; 90) according to Claim 1 wherein the monitoring module (12) is configured to consider an on-state voltage across the switching device and includes a voltage monitoring circuit (20) configured to in use provide a monitoring output proportional to the voltage ($V_{GT}$) arising across the switching device (14), the voltage monitoring circuit (20) being configured to operate in a first mode while the switching device (14) is conducting in which it is configured to communicate the whole voltage magnitude ($V_{GT}$) arising across the switching device (14), and the voltage monitoring circuit (20) being configured to operate in a second mode while the switching device (14) is not conducting in which it is configured to truncate at least a portion of the whole voltage magnitude ($V_{GT}$) arising across the switching device (14).

3. A monitoring assembly (10; 50; 70; 80; 90) according to Claim 2 wherein the voltage monitoring circuit (20) includes a voltage divider stage (24) having a monitoring output (22) configured to provide a monitoring output voltage ($V_{MO}$) proportional to the voltage ($V_{GT}$) arising across the switching device (14).

4. A monitoring assembly (10; 50; 70; 80; 90) according to Claim 3 wherein the voltage divider stage (24) includes a limiter (32; 94) to truncate at least a portion of the whole voltage magnitude ($V_{GT}$) arising across the switching device (14) while the switching device (14) is not conducting.

5. A monitoring assembly (50; 70; 80; 90) according to Claim 4 wherein the limiter (32; 94) is or includes a non-linear resistor (58; 96) electrically connected across the monitoring output (22) of the voltage divider stage (24).

6. A monitoring assembly (10; 50; 70; 80; 90) according to Claim 4 or Claim 5 wherein the limiter (32; 94) is configured to retain only a lowermost portion of the whole voltage magnitude ($V_{GT}$) arising across the switching device (14) while the switching device (14) is not conducting.

7. A monitoring assembly (90) according to any of Claims 4 to 6 wherein the limiter (32) is or includes a switching element (92) configured to electrically isolate the monitoring output from the voltage divider stage while the switching device is not conducting.

8. A monitoring assembly (90) according to Claim 7 wherein during normal use the switching element (92) is configured to remove the whole of the voltage magnitude ($V_{GT}$) arising across the switching device (14) while the switching device (14) is not conducting.

9. A monitoring assembly (50; 70; 80; 90) according to any of Claims 3 to 8 wherein the voltage monitoring circuit (20) includes a further voltage divider stage (52) having a control output (38) configured to provide a control output voltage (Vco) proportional to the voltage ($V_{GT}$) arising across the switching device (14).

10. A monitoring assembly (50; 70; 80; 90) according to Claim 9 wherein the divider ratio of the further voltage divider stage (52) having a control output (38) is greater than the divider ratio of the voltage divider stage (24) having a monitoring output (22).

11. A monitoring assembly (50; 70; 80; 90) according to Claim 10 wherein the divider ratio of the further voltage divider stage (52) is multiple orders of magnitude greater than that of the other voltage divider (24).

12. A monitoring assembly according to Claim 1 wherein the monitoring module is configured to consider an electromagnetic emission from the switching device and includes an electromagnetic detector arranged in electromagnetic communication with the switching device.

13. A system comprising a gas tube switching device (14), for use in HVDC power transmission, operable in a plurality of different conducting modes and a monitoring assembly (10; 50; 70; 80; 90) according to any preceding claim connected therewith.

**Patentansprüche**

1. Überwachungsanordnung (10; 50; 70; 80; 90) für eine Gasrohrrangiervorrichtung (14), die in einer Vielzahl von unterschiedlichen Leitungsmodi betriebsfähig ist, wobei die Überwachungsanordnung (10; 50; 70; 80; 90) **dadurch gekennzeichnet ist, dass** sie ein Überwachungsmodul (12) beinhaltet, das parallel mit jeweiligen Anoden- und Kathodenverbindungsanschlüssen (16, 18) der Gasrohrrangiervorrichtung (14) verbunden werden kann, um in Echtzeit mindestens einen Leitungsmodus von vier unterschiedlichen Leitungsmodi zu unterscheiden, die wie folgt gekennzeichnet sein können:

(i) ein Magnetronmodus mit einer Einspannung über die Anoden- und Kathodenverbindungsanschlüsse (16, 18) davon von etwa 200V bis 300V;
(ii) ein Niederspannungsmodus mit einer Einspannung über die Anoden- und Kathodenverbindungsanschlüsse (16, 18) davon von etwa 70V bis 120V;
(iii) ein Ultraniederspannungsmodus mit einer Einspannung über die Anoden-und Kathodenverbindungsanschlüsse (16, 18) davon von etwa 40V bis 60V; und
(iv) ein Metallmodus mit einer Einspannung über die Anoden- und Kathodenverbindungsanschlüsse (16, 18) davon von etwa 6V bis 30V; wobei das Überwachungsmodul (12) in Verwendung den mindestens einen Leitungsmodus unterscheidet, indem, während die Rangiervorrichtung leitend ist, eines oder mehr berücksichtigt wird von:

- einer elektromagnetischen Emission der Rangiervorrichtung (14); und
- einer Betriebstemperatur der Rangiervorrichtung (14).

2. Überwachungsanordnung (10; 50; 70; 80; 90) nach Anspruch 1, wobei das Überwachungsmodul (12) konfiguriert ist, eine Einspannung über die Rangiervorrichtung zu berücksichtigen und eine Spannungsüberwachungsschaltung (20) beinhaltet, die konfiguriert ist, in Verwendung einen Überwachungsausgang proportional zu der Spannung ($V_{GT}$) bereitzustellen, die über die Rangiervorrichtung (14) anfällt, wobei die Spannungsüberwachungsschaltung (20) konfiguriert ist, in einem ersten Modus zu arbeiten, während die Rangiervorrichtung (14) leitend ist, in dem sie konfiguriert ist, die gesamte Spannungsgröße ($V_{GT}$) zu kommunizieren, die über die Rangiervorrichtung (14) anfällt, und wobei die Spannungsüberwachungsschaltung (20) konfiguriert ist, in einem zweiten Modus zu arbeiten, während die Rangiervorrichtung (14) nicht leitend ist, in dem sie konfiguriert ist, mindestens einen Abschnitt der gesamten Spannungsgröße ($V_{GT}$) zu kürzen, die über die Rangiervorrichtung (14) anfällt.

3. Überwachungsanordnung (10; 50; 70; 80; 90) nach Anspruch 2, wobei die Spannungsüberwachungsschaltung (20) eine Spannungsteilerstufe (24) beinhaltet, die einen Überwachungsausgang (22) aufweist, der konfiguriert ist, eine Überwachungsausgangsspannung ($V_{MO}$) proportional zu der Spannung ($V_{GT}$) bereitzustellen, die über die Rangiervorrichtung (14) anfällt.

4. Überwachungsanordnung (10; 50; 70; 80; 90) nach Anspruch 3, wobei die Spannungsteilerstufe (24) einen Begrenzer (32; 94) beinhaltet, um mindestens einen Abschnitt der gesamten Spannungsgröße (V_{GT}) zu kürzen, die über die Schaltungsvorrichtung (14) anfällt, während die Rangiervorrichtung (14) nichtleitend ist.

5. Überwachungsanordnung (50; 70; 80; 90) nach Anspruch 4, wobei der Begrenzer (32; 94) ein nichtlinearer Widerstand (58; 96) ist oder diesen beinhaltet, der elektrisch über den Überwachungsausgang (22) der Spannungsteilerstufe (24) verbunden ist.

6. Überwachungsanordnung (10; 50; 70; 80; 90) nach Anspruch 4 oder Anspruch 5, wobei der Begrenzer (32; 94) konfiguriert ist, nur einen untersten Abschnitt der gesamten Spannungsgröße (V_{GT}) zu begrenzen, die über die Rangiervorrichtung (14) anfällt, während die Rangiervorrichtung (14) nichtleitend ist.

7. Überwachungsanordnung (90) nach einem der Ansprüche 4 bis 6, wobei der Begrenzer (32) ein Rangierelement (92) ist oder dieses beinhaltet, das konfiguriert ist, den Überwachungsausgang elektrisch von der Spannungsteilerstufe zu isolieren, während die Rangiervorrichtung nichtleitend ist.

8. Überwachungsanordnung (90) nach Anspruch 7, wobei während normaler Verwendung das Rangierelement (92) konfiguriert ist, die gesamte Spannungsgröße (V_{GT}) zu entfernen, die über die Rangiervorrichtung (14) anfällt, während die Rangiervorrichtung (14) nichtleitend ist.

9. Überwachungsanordnung (50; 70; 80; 90) nach einem der Ansprüche 3 bis 8, wobei die Spannungsüberwachungsschaltung (20) eine weitere Spannungsteilerstufe (52) beinhaltet, die einen Steuerungsausgang (38) aufweist, der konfiguriert ist, eine Steuerungsausgangsspannung (V_{CO}) proportional zu der Spannung (V_{GT}) bereitzustellen, die über die Rangiervorrichtung (14) anfällt.

10. Überwachungsanordnung (50; 70; 80; 90) nach Anspruch 9, wobei das Teilerverhältnis der weiteren Spannungsteilerstufe (52), die einen Steuerungsausgang (38) aufweist, größer als das Teilerverhältnis der Spannungsteilerstufe (24) ist, die einen Überwachungsausgang (22) aufweist.

11. Überwachungsanordnung (50; 70; 80; 90) nach Anspruch 10, wobei das Teilerverhältnis der weiteren Spannungsteilerstufe (52) einige Größenordnungen größer als das des anderen Spannungsteilers (24) ist.

12. Überwachungsanordnung nach Anspruch 1, wobei das Überwachungsmodul konfiguriert ist, eine elektromagnetische Emission von der Rangiervorrichtung zu berücksichtigen und einen elektromagnetischen Detektor beinhaltet, der in elektromagnetischer Kommunikation mit der Rangiervorrichtung eingerichtet ist.

13. System, das eine Gasrohrrangiervorrichtung (14) zur Verwendung in HVDC-Stromübertragung, das in einer Vielzahl unterschiedlicher Leitungsmodi betrieben werden kann, und eine damit verbundene Überwachungsanordnung (10; 50; 70; 80; 90) nach einem der vorstehenden Ansprüche umfasst.

**Revendications**

1. Ensemble de surveillance (10; 50; 70; 80; 90), pour un dispositif de commutation de tube à gaz (14) pouvant fonctionner dans une pluralité de modes conducteurs différents, l'ensemble de surveillance (10; 50; 70; 80; 90) **caractérisé par** le fait d'inclure un module de surveillance (12) pouvant être connecté en parallèle avec des bornes de connexion d'anode et de cathode respectives (16,18) du dispositif de commutation de tube à gaz (14) pour distinguer en temps réel au moins un mode conducteur parmi quatre modes conducteurs différents qui peuvent être caractérisés comme suit :

(i) un mode magnétron avec une tension à l'état passant à travers les bornes de connexion d'anode et de cathode (16, 18) de celui-ci d'approximativement 200 V à 300 V ;
(ii) un mode basse tension avec une tension à l'état passant à travers les bornes de connexion d'anode et de cathode (16, 18) de celui-ci d'approximativement 70V à 120 V
(iii) un mode de très basse tension avec une tension à l'état passant à travers les bornes de connexion d'anode et de cathode (16,18) de celui-ci d'approximativement 40 V à 60 V ; et
(iv) un mode métallique avec une tension à l'état passant à travers les bornes de connexion d'anode et de cathode (16, 18) de celui-ci d'approximativement 6 V à 30V ; dans lequel le module de surveillance (12) en cours d'utilisation distingue l'au moins un mode conducteur en considérant, tandis que le dispositif de commutation est conducteur, un ou plusieurs parmi :

- une émission électromagnétique provenant du dispositif de commutation (14) ; et
- une température de fonctionnement du dispositif de commutation (14).

2. Ensemble de surveillance (10; 50; 70; 80; 90) selon la revendication 1 dans lequel le module de surveillance (12) est configuré pour considérer une tension à l'état passant à travers le dispositif de commutation et inclut un circuit de surveillance de tension (20) configuré pour, en cours d'utilisation, fournir une sortie de surveillance proportionnelle à la tension ($V_{GT}$) émanant à travers le dispositif de commutation (14), le circuit de surveillance de tension (20) étant configuré pour fonctionner dans un premier mode tandis que le dispositif de commutation (14) est conducteur dans lequel il est configuré pour communiquer la magnitude de tension totale ($V_{GT}$) émanant à travers le dispositif de commutation (14), et

le circuit de surveillance de tension (20) étant configuré pour fonctionner dans un second mode tandis que le dispositif de commutation (14) n'est pas conducteur dans lequel il est configuré pour tronquer au moins une partie de l'amplitude de tension totale ($V_{GT}$) émanant à travers le dispositif de commutation (14).

3. Ensemble de surveillance (10; 50; 70; 80; 90) selon la revendication 2 dans lequel le circuit de surveillance de tension (20) inclut un étage diviseur de tension (24) présentant une sortie de surveillance (22) configurée pour fournir une tension de sortie de surveillance ($V_{MO}$) proportionnelle à la tension ($V_{GT}$) émanant à travers le dispositif de commutation (14).

4. Ensemble de surveillance (10; 50; 70; 80; 90) selon la revendication 3 dans lequel l'étage diviseur de tension (24) inclut un limiteur (32; 94) pour tronquer au moins une partie de la grandeur de tension totale ($V_{GT}$) émanant à travers le dispositif de commutation (14) tandis que le dispositif de commutation (14) n'est pas conducteur.

5. Ensemble de surveillance (50; 70; 80; 90) selon la revendication 4 dans lequel le limiteur (32; 94) est ou inclut une résistance non linéaire (58; 96) connectée électriquement à travers la sortie de surveillance (22) de l'étage diviseur de tension (24).

6. Ensemble de surveillance (10; 50; 70; 80; 90) selon la revendication 4 ou la revendication 5 dans lequel le limiteur (32; 94) est configuré pour retenir uniquement une partie la plus inférieure de l'amplitude de tension totale ($V_{GT}$) émanant à travers le dispositif de commutation (14) tandis que le dispositif de commutation (14) n'est pas conducteur.

7. Ensemble de surveillance (90) selon l'une quelconque des revendications 4 à 6 dans lequel le limiteur (32) est ou inclut un élément de commutation (92) configuré pour isoler électriquement la sortie de surveillance de l'étage diviseur de tension tandis que le dispositif de commutation n'est pas conducteur.

8. Ensemble de surveillance (90) selon la revendication 7 dans lequel, pendant une utilisation normale, l'élément de commutation (92) est configuré pour retirer l'entièreté de l'amplitude de tension ($V_{GT}$) émanant à travers le dispositif de commutation (14) tandis que le dispositif de commutation (14) n'est pas conducteur.

9. Ensemble de surveillance (50 ; 70 ; 80 ; 90) selon l'une quelconque des revendications 3 à 8 dans lequel le circuit de surveillance de tension (20) inclut un étage diviseur de tension supplémentaire (52) présentant une sortie de commande (38) configurée pour fournir une tension de sortie de commande (Vco) proportionnelle à la tension ($V_{GT}$) émanant à travers le dispositif de commutation (14).

10. Ensemble de surveillance (50; 70; 80; 90) selon la revendication 9 dans lequel le rapport de division de l'étage diviseur de tension supplémentaire (52) présentant une sortie de commande (38) est supérieur au rapport de division de l'étage diviseur de tension (24) présentant une sortie de surveillance (22).

11. Ensemble de surveillance (50; 70; 80; 90) selon la revendication 10 dans lequel le rapport de division de l'étage diviseur de tension supplémentaire (52) est de plusieurs ordres de grandeur supérieur à celui de l'autre diviseur de tension (24).

12. Ensemble de surveillance selon la revendication 1 dans lequel le module de surveillance est configuré pour considérer une émission électromagnétique provenant du dispositif de commutation et inclut un détecteur électromagnétique agencé en communication électromagnétique avec le dispositif de commutation.

13. Système comprenant un dispositif de commutation de tube à gaz (14), pour une utilisation dans la transmission de puissance CCHT, pouvant fonctionner dans une pluralité de modes conducteurs différents et un ensemble de surveillance (10; 50; 70; 80; 90) selon l'une quelconque des revendications précédentes relié à celui-ci.

FIG. 1

FIG. 2

FIG. 3

FIG. 4

**EP 3 337 026 B1**

## REFERENCES CITED IN THE DESCRIPTION

### Patent documents cited in the description

- US 2575232 A
- US 4156264 A